# EUROPEAN PATENT APPLICATION

(11) **EP 4 484 352 A1**
(43) Date of publication of application: **01.01.2025**
(21) Application number: 23189372.8
(22) Date of filing: 03.08.2023
(51) Int. Cl.: B66B 7/12, G01N 27/83

(54) **POSITION CONTROL SYSTEM FOR MAGNETIC DIAGNOSTICS OF STEEL ROPES AND A MEASURING HEAD**

(30) Priority: 30.06.2023 PL 44542623
(71) Applicant: Akademia Gorniczo-Hutnicza im. Stanislawa Staszica w Krakowie, 30-059 Krakow (PL)
(72) Inventor: Kwasniewski, Jerzy, 30-211 Kraków (PL); Molski, Szymon, 31-901 Kraków (PL); Roskosz, Maciej, 42-677 Sza sza (PL); Grzybowski, Józef, 35-329 Rzeszów (PL)
(74) Representative: Balinska, Ewa

(57) **Abstract**

The subject of the invention relates to a system for adjustment of a position of measuring sensors for magnetic diagnostics of steel ropes using a passive method, and a measuring head consisting of two head halves, to which head the adjustment system is permanently connected, wherein the system for adjustment of a position of measuring sensors consists of two half-rings, upper and lower (1, 2), which are arranged one opposite to each other around the tested rope (9) and which are connected to each other rotatably by an articulated joint (3), while on each of the half-rings a number of measuring sensors (8) are arranged around the tested rope on each half-ring (1 or 2), the system being characteristic by that the measuring sensors (8) are fixed by means of displacement mechanisms on each of the half-rings (1 and 2), wherein the displacement mechanisms are in the form of kinematic pairs, each of which contains a toothed wheel (5) and a toothed bar (4), and wherein the toothed bars (4) are spaced radially at intervals in each half-ring (1 and 2) in such a way as to allow their simultaneous, centrifugal and sliding displacement in a radial direction, and whereas at least one magnetometer sensor (8) is attached on each radially inner end of the toothed bar (4), while the other opposite end of each toothed bar (4) is couplingly connected by engagement to the corresponding toothed wheel (5).

## Description

The subject matter of the invention is a system for adjustment position of measuring sensors for magnetic diagnostics of steel ropes, particularly compacted steel ropes, while using a passive method that employs multi-channel recording of magnetic remanence by means of simultaneous recording from multiple measuring sensors, particularly magnetometric sensors distributed around the perimeter of the tested rope. The subject matter of the invention also relates to a measuring head with such an adjustment system.

### Description of the background art

A device for evaluation of magnetization inhomogeneities in steel wire ropes is known from patent description No. PL 235612B1 that allows the detection of magnetic anomalies or inhomogeneities occurring in certain places or areas in wire ropes, which indicate accelerated wear or are symptoms of such accelerated wear of such ropes, for example, these may be places of wire cracks in wire ropes used in mining industry, cable railways, masts with lashings, rope bridges, etc.

The device consists of a measuring system, a recorder, an analyzer and a decision-making system for indicating a location of such damages and counting damages. The measuring system consists of ring slices of predetermined width that are distributed evenly around the rope under test on the diameter D, wherein on each ring slice two tri-axial magnetometer sensors are located, arranged in pairs and spaced from each other by a well-defined distance. The magnetometer sensors are integrated with the tri-axial accelerometer sensors of the device by means of the analyzer and provide information about the position of the measuring system and about values and distribution of the dissipated magnetic field around the tested rope. The analyzer corrects the measurement result by subtracting of the value of the earth magnetic field from the measured value of the dissipated field, which makes it possible to measure the residual magnetism of the rope under test and to evaluate inhomogeneity of the field caused by discontinuities in its structure. The device makes it possible to detect cracks in wires of the rope that do not exhibit gaps and to indicate vectorial location of the damage across the entire cross-section of the rope and not only on its surface. Additionally the device has a light weight and simple construction. The device is limited in construction and design due to the need to adapt it to the diameter of the tested rope within a fairly limited range. The signal recording sensitivity of the device depends on possibly close proximity of the sensors of the sensors to the rope surface and can vary within the assumed range of rope diameters, which is important for the damage (wire cracks) without detected gaps.

Patent No. PL 211613 B1 discloses a head for nondestructive diagnostic testing of steel (wire) ropes which head uses the effect of a metal magnetic memory in the geomagnetic i.e. earth magnetic field. The head moves by way of linear motion along the rope and is equipped with magnetic sensors that are spaced every 90° radially, around the tested rope, adapted for measuring the magnetic field strength (tangential and normal component). The measured magnetic field is volumetric field and the distribution of stress concentration lines in the tested rope has a spatial characteristics of the course. In the stress concentration areas that indicate existing weaknesses in the rope, such as wire cracks, rapid changes in the condition of the rope can occur during operation, having an adverse effect on the safety of the rope during working .

Another head for nondestructive diagnostic testing of wire ropes operating on a similar principle is known from the patent No. PL 210042 B1.

A diagnostic device for non-destructive continuous detection of magnetic flux leakage in the defectoscopy of steel ropes is also known from Chinese patent description CN111175373 (A) that are used in winches or hoists operating in mines, which device allows detection of places in which the rope structure is damaged. The device includes a magnetic field excitation system, a rope vibration compensation unit and a magnetic detection unit. The magnetic detection assembly is equipped with a driving mechanism cooperating with an adjustment system for adjusting a unit of three index disks of different inner diameters to which sensors are attached, the index disks being fixed on a block of rotating disks in such a way as to create a 360° measuring field around the rope under test for detecting the leakage of magnetic flux or the distribution of the magnetic field inside the tested rope. In the block of motor-driven driving discs, the index discs of the adjustment system can be moved up and down relative to the rope under test, whereby it is possible to determine the exact position of the tested rope area. The presented device is stable and allows to obtain reliable detection data about damages in ropes continuously in the workplace, however, its design is complicated and requires high stability of the rope area under test, which is difficult to obtain in the conditions of normal mine operation.

Also known are devices for nondestructive diagnostics of wire ropes and cables in which the magnetic field excitation elements are modules containing permanent magnet assemblies, for example, disclosed in publications No. EP3006932(A1), EP1923700(B1).

### The aim of the invention and advantage effects

Currently existing solutions of measuring heads that are used in steel wire rope defectoscopy cannot easily and reliably detect changes caused by wire cracks in which the air gap is close to zero. In addition, in order to simplify the diagnostic device, it would be advantageous to eliminate the need to generate a magnetic field using an external magnetic field source in the form of permanent magnets and, for example, inductive sensors to generate measurement signals. At the moment, on the market there is a lack of industrial diagnostic methods for compacted ropes, in which there are no clear air gaps in places of wire cracks during operation.

Therefore, the aim of the invention is to develop steel wire rope defectoscopy by means of a passive method, without the need of using magnetic field excitation circuits. In this passive method multi-channel recording of magnetic anomaly by simultaneous recording signals from multiple magnetometric sensors located on the perimeter of the tested rope is employed and in which, moreover, the need to generate a magnetic field using an external source (permanent magnets or resonant circuits, for example, inductive) is eliminated. In this way, the total weight of the detecting device is reduced, which plays a significant role in specialized applications, for example, in strand structures. The lack of need for external magnetization is due to the fact that, according to the invention, the phenomenon of magnetic remanence of a ferromagnetic structure located in the earth magnetic field is used in diagnostics, and this is the so-called passive method.

The adjustment system according to the invention ensures rapid adjustment of the centrifugal measurement sensor system to the preset diameter of the tested rope, which is a basic condition for maintaining the appropriate sensitivity of signal recording.

Another aim of the invention is to provide a system for adjustment a position of sensors of measuring head that, in the earth's magnetic field, allow detection of changes caused by wire cracks in which the air gap is close to zero.

According to the invention, the adjustment system of a position of sensors makes it possible to quickly adjust the magnetometer sensor system arranged in centrifugal configuration to the preset diameter of the rope under test, thus ensuring the versatility of the adjustment system, which can be applied to a wide range of diameters of the ropes under test in a simple manner.

According to the invention, a system for adjustment position of magnetometer sensors arranged in a centrifugal configuration is used, which makes it possible to maintain identical air gap between the sensors of the system located around the rope circumference and the surface of the tested rope.

According to the invention, additional magnetic flux forming elements are eliminated from the diagnostic device. Consequently, the system does not contain classical heavy elements forming the flow of magnetic flux through the rope, and therefore the whole structure of the device is lightweight.

### Essence of the invention

System for adjustment a position of measuring sensors for magnetic diagnostics of steel ropes, particularly compacted wire steel ropes is presented which uses a passive method, in which multi-channel recording of magnetic remanence is employed by simultaneous recording signal from a plurality of measuring sensors, preferably, magnetometric sensors that are evenly distributed around the circumference of the tested rope, by means of a measuring head consisting of two head halves, to which the position adjustment system of measuring sensor is fixedly connected. The system for adjustment consists of two half-rings, upper and lower, placed opposite to each other around the tested rope and which are connected to each other pivotally by articulated joint, while on each of the half-rings a number of measuring sensors are located and arranged around the rope under test and on each of the half-rings mechanisms for moving the measuring sensors in the radial direction with respect to the tested rope are mounted. The system according to the invention is characteristic by measuring sensors that are fixed by means of displacement mechanisms on each of the half-rings, wherein the displacement mechanisms are in the form of kinematic pairs, each of which contains a toothed wheel and a toothed bar. The toothed bars are spaced radially at intervals in each of half-rings in such a way as to allow their simultaneous, centrifugal and sliding displacement in the radial direction, and at least one magnetometer sensor is mounted on each radially inner end of each toothed bar, whereas the other, opposite end of each toothed bar is connected by engagement to the corresponding toothed wheel located on the corresponding upper or lower half-ring, respectively, and wherein all the toothed wheels located on one of the upper and/or lower half-rings are connected to each other by means of flexible driving axes and they are rotationally driven to perform rotation movement by means of a knob, one separate knob for each half-ring is provided.

In preferable embodiment, the rotation movement of the toothed wheels is realized simultaneously by means of the knob separately for the upper half-ring and the lower half-ring, particularly manually.

In an advantageous embodiment, the magnetometer sensors mounted on the radially inner ends of the toothed bars are positioned in a distance above the surface of the tested rope, while maintaining the required distance A from the surface of this rope, which distance depends on the diameter of the rope.

In preferred embodiment, the toothed bars are located radially in each half-rings, lower and upper, for moving within a distance range that guarantees the testing of ropes having diameters of from 20 to 60 mm while the knob makes a full rotation, wherein a constant distance *h* of the magnetometer sensors from the surface of the rope is maintained, which distance *h* is within the limits of 2 - 4 mm regardless of the diameter of the rope under test.

In preferred embodiment, magnetometric sensors measuring a dissipated magnetic field of remanence of the rope are used as the measuring sensors; advantageously, magnetometric sensors measuring three components of the dissipated magnetic field of the rope are used, alternatively, gradient magnetometric sensors measuring the differences in the values of the magnetic field are used.

In preferred embodiment, the rotational movement of the toothed wheels is realized by using flexible driving axes that connect all the toothed wheels of a given upper and/or lower half-ring one to another, and this rotational movement is activated by the knob to which the flexible driving axes are connected by a drive connection. The diameter of the toothed wheels are selected so that one full rotation of the toothed wheel causes the centrifugal displacement of the corresponding toothed bars with magnetometric sensors for a distance within a range of up to 20 mm.

In preferred embodiment, the adjustment system is stabilized with respect to the rope under test by means of rollers moving along the rope under test.

The essence of the invention relates to also a measuring head for defectoscopy of wire steel ropes by means of measuring sensors for magnetic diagnostics of steel ropes, particularly compacted wire steel ropes using the passive method, which measuring head consists of two head halves, which are connected one to the other by way of articulated joint, being characteristic by containing a fixedly connected to it the system for adjustment a position of measuring sensors described above.

### Description of figures of the drawing

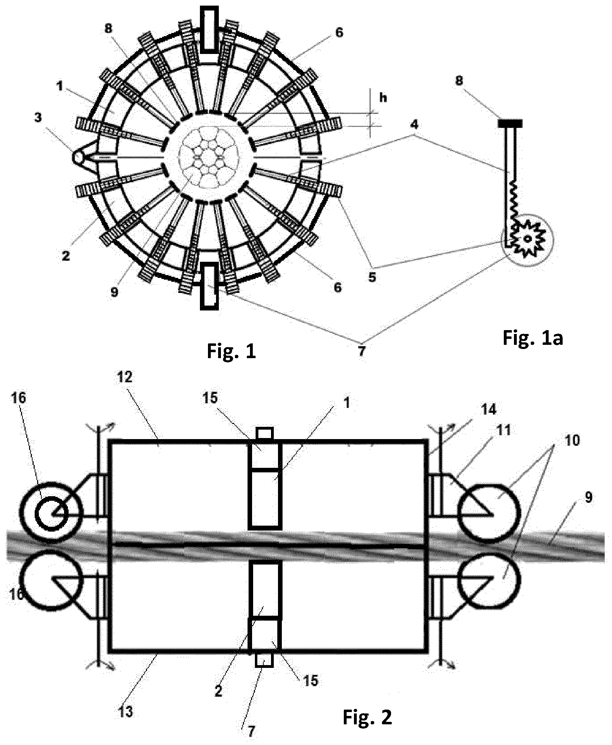

The system for adjustment position of measuring sensors according to the invention in the embodiment is shown in the drawing, in which: fig. 1 shows the adjustment system in schematic front view, fig. 1a shows in schematic side view a section of a driving assembly, for moving the measuring sensors, containing a toothed wheel and a toothed bar, and fig. 2 shows in a schematic side view a measuring head, for steel rope diagnostics, with the adjustment system of a position of measuring sensors according to the invention.

### Description of an embodiment of the invention

The system for adjustment position of magnetometer sensors for diagnostics of compacted steel ropes and other wire ropes in the embodiment according to the invention is designed to cooperate with a measuring head 14 consisting of two head halves 12 and 13, which are connected one to each other by means of an articulated joint 3, also referred to as a joint 3, in such a way that they can be opened by tilting one with respect to each other, wherein the measuring head 14 being axially positioned with respect to the tested rope 9 and around this rope 9 under test, as shown in fig. 2. The sensor position adjustment system is located in the central area of the length of the halves 12 and 13 of the head and is permanently connected to both of them by means of connecting structural members 15. The adjustment system in the embodiment according to the invention consists of two half-rings, upper 1 and lower 2, on which the measuring sensors 8 are mounted via a displacement mechanism, and which half-rings 1, 2 are placed opposite to each other around the tested rope 9 and they are connected one to each other by the mentioned articulated joint 3, which preferably connects the head halves 12 and 13 of the head. This makes it possible to put it on the rope 9 under test. Each of the half-rings upper 1 and lower 2, respectively, is permanently connected by means of connecting structural members 15 to the corresponding head half 12 or 13 of the head. The position adjusting system is stabilized with respect to the tested rope 9 by means of rollers 10 moving along and on the rope 9 under test, each roller is connected via sliding mechanisms 11 to the corresponding half 12 or 13 of the head. In the embodiment shown in fig. 2, the measuring head 14 with the position adjustment system is equipped with four rollers 10, each of which is connected to a corresponding slider mechanism 11. By using rollers 10 that moves along the tested rope 9 with the possibility of adjusting them using slider mechanisms 11, axial alignment of the adjustment system and the entire measuring head 14, consisting of the head halves 12, 13 with respect to the rope 9 is ensured.

In each half-ring 1, 2 radial displacement mechanisms are mounted having radially mounted toothed bars 4, spaced at equal intervals with respect to each other along peripheral surface of each half-ring 1,2. At the inner ends of these toothed bars 4 measuring sensors 8 are mounted, in preferred embodiment eight toothed bars 4 and 8 measuring sensors 8 are mounted in each half-ring 1 and 2. A toothed wheel 5 is mounted on each of half-rings 1 and 2 on the side of the opposite outer end of each toothed bar 4, which is connected and coupled by engagement to the corresponding toothed bar 4 (fig. 1a), which the toothed wheels 5 are driven by means of a flexible driving axles 6 running along the outer periphery of each of half-rings 1 and 2 and connected to a knob 7 by a drive. The toothed bars 4 are located radially in the half-rings 1 and 2 of the adjustment system for simultaneous, centrifugal and sliding movement in the radial direction driven by means of the rotation of the toothed wheels 5, that are rotated by using the knob 7, to which the corresponding flexible driving axes 6 are connected. The movement is possible within a range that guarantees the testing of ropes 9 having a diameter, preferably, in the range from 20 to 60 mm, when the knob 7 performs a full rotation. The toothed bars 4 are driven by the toothed wheels 5 attached to the half-rings 1 and 2, move slidingly in the profiled openings in the half-rings 1 and 2. All the toothed wheels 5 that are located on each of half-rings 1 and 2 are connected to each other by means of flexible driving axes 6 and their rotational movement is performed simultaneously, advantageously realized manually, by the knob 7, separately for the upper half-ring 1 and the lower half-ring 2.

The drive of the toothed bars 4 is realized by means of toothed wheels 5, which are located on each of the half-rings, upper 1 and lower 2, and connected to flexible driving axes 6. The rotational movement of the toothed wheels 5 is enabled by means of flexible driving axes 6 connecting one to another all the toothed wheels 5 of each one of the half-rings 1 and 2. This movement is produced and possible by the rotation of the knob 7, to which the flexible driving axes 6 are connected by a drive. The flexible axes 6 can be made of a plastic or a rubber, for example. The diameter of the toothed wheels 5 is selected so that its one single full rotation causes centrifugal displacement of the toothed bars 4 together with measuring sensors 8 over a distance in the range of up to 20 mm. This range of movement of toothed bars 4 allows for measurement of a rope having a diameter in the range of from 20 to 60 mm. The presented arrangement of measuring sensors 8 on the perimeter around the tested rope 9 allows to collect information about magnetic anomalies that occur in it caused by operational changes (passive method, i.e. without excitation of the magnetic field but only in the earth magnetic field, also named geomagnetic field). All the measurement sensors 8 are connected to a recorder, in which their signals are processed, filtered and analyzed.

In the adjustment system of position according to the invention, magnetometric sensors 8 are used as measuring sensors 8 measuring the dissipated magnetic field remanence of the rope, wherein preferably magnetometric sensors 8 measuring three components of the dissipated magnetic field of remanence of the rope 9 can be used, alternatively, gradient magnetometric sensors measuring differences in the values of the magnetic field may be used.

The knobs 7 of each half-ring 1 and 2, by means of which, by rotating them, the alignment of the toothed bars 4 and therefore of the measuring sensors 8 located at their ends is adjusted with respect to the diameter of the tested rope 9, are arranged in corresponding openings located in each head half 12 and 13 of the measuring head 14, one knob is provided (separately) for each half-ring. The halves 12 and 13 of the head 14 and the half-rings 1 and 2 of the adjustment system are respectively connected to each other rotatably by means of a joint 3.

According to the invention, in the measuring head 14 in which the presented sensor 8 position adjustment system is included, a passive method of measurement is adopted in which magnetometric sensors 8 are used and in which changes of magnetic remanence in the geomagnetic field that results from changes in the material structure of the tested rope 9 at the locations in which a crack or cracks potentially occur in their initial phase, are registered. A prerequisite for the registration of these changes is sufficiently close distance A of the magnetometric sensors 8 from the surface of the rope 9 under test. Determination of the location of the changes in remanence is possible, for example, by using an encoder 16 in one of the rollers 10, as shown in the embodiment in fig. 2.

The use of eight magnetometer sensors 8 for each half-ring 1, 2 of the adjustment system, as shown in fig. 1, iresults from the dimension of the used sensors, which dimension is about 6 mm when testing a rope 9 having a diameter of 20 mm while maintaining a constant distance *h* of the sensors 8 from the surface of the tested rope, which distance *h* is within the range of 2 - 4 mm regardless of the diameter of the rope 9 under test. Of course, both the number of measuring sensors and the diameter of the rope under test can be appropriately changed and adjusted according to requirements. Flexible axes 6 guarantee the realization of movement of the knob 7 which drives the toothed wheels 5 and simultaneous displacement of the toothed bars 4 together with the measuring sensors 8 corresponding to the preset diameter of the tested rope 9. This flexibility is required due to the non-parallel alignment of the toothed wheels 5 one with respect to each other. On the knob 7 there are markers corresponding to the diameter of the rope 9 under test.

## Claims

1. System for adjustment of a position of measuring sensors for magnetic diagnostics of steel ropes, particularly compacted steel ropes, by using a passive method, in which multi-channel recording of magnetic remanence is employed by simultaneous recording signals from a plurality of measuring sensors, preferably magnetometric sensors, that are distributed evenly around the circumference of the tested rope, by means of a measuring head consisting of two head halves, to which the system for adjustment is permanently connected, wherein the adjustment system of a position of measuring sensors consists of two half-rings, upper and lower (1, 2), which are arranged one opposite to each other around the tested rope (9) and which are connected to each other rotatably by an articulated joint (3), while on each of the half-rings a number of measuring sensors (8) are arranged around the tested rope and mechanisms for moving the measuring sensors in the radial direction with respect to the tested rope are mounted,
**characterized in that**
the measuring sensors (8) are fixed by means of displacement mechanisms on each of the half-rings (1 and 2), wherein the displacement mechanisms are in the form of kinematic pairs, each of which contains a toothed wheel (5) and a toothed bar (4), and wherein the toothed bars (4) are spaced radially at intervals in each half-ring (1 and 2) in such a way as to allow their simultaneous, centrifugal and sliding displacement in a radial direction, and whereas at least one magnetometer sensor (8) is attached on each radially inner end of the toothed bar (4), while the other opposite end of each toothed bar (4) is couplingly connected by engagement to the corresponding toothed wheel (5), located respectively on the corresponding half-ring upper (1) or lower (2), and further wherein all toothed wheels (5) located on the respective of half-rings upper (1) and/or lower (2), are connected to each other by means of flexible driving axes (6) and they are rotationally driven to perform rotations by means of a knob (7), one separate for each half-ring (1, 2).

2. The system according to claim 1, **characterized in that** the rotational movement of the toothed wheels (5) is realized by means of the knob (7) simultaneously and separately for the upper half-ring (1) and for the lower half-ring (2), especially manually.

3. The system according to one of the claims 1 - 2, **characterized in that** the magnetometer sensors (8) mounted on the radially inner ends of the toothed bars (4) are positioned in spaces over the surface of the tested rope (9), while maintaining the desired distance *h* from the surface of this rope (9), which distance depends on the diameter of the rope (9).

4. The system according to one of claims 1 - 3, **characterized in that** the toothed bars (4) are located radially in each of half-rings lower (2) and upper (1), with the possibility of performing simultaneous and sliding movement in centrifugal direction within a range that guarantees testing of the rope (9) having a diameter of from 20 to 60 mm while the knob (7) performs one full rotation, wherein a constant distance *h* of the sensors (8) from the surface of the tested rope is maintained, which distance *h* is within the limits of from 2 to 4 mm regardless of the diameter of the rope (9) under test.

5. The system according to one of the claims 1-4, **characterized in that** the magnetometric sensors (8) measuring the dissipated magnetic field of remanence of the rope are used as measuring sensors (8), wherein, preferably, magnetometric sensors (8) measuring the three components of the dissipated magnetic field of the tested rope (9) are used, alternatively magnetometric gradient sensors measuring the differences in the values of the magnetic field are used.

6. The system according to one of claims 1 - 5, **characterized in that** the rotational movement of the toothed wheels (5) is realized by using of flexible driving axes (6), that connect, one to another, all the toothed wheels (5) of a given half-ring upper (1) and/or lower (2), and this rotational movement is activated by the knob (7), to which the flexible driving axes (6) are connected by a drive, wherein the diameter of the each of toothed wheels (5) is selected so that, one rotation of the toothed wheels causes centrifugal displacement of the corresponding toothed bars (4) with magnetometer sensors (8) for a distance within a range of up to 20 mm.

7. The system according to one of claims 1 - 6, **characterized in that** it is stabilized with respect to the rope (9) under test by means of rollers (10) moving on the rope (9) under test.

8. A measuring head for defectoscopy of steel ropes by means of measuring sensors for magnetic diagnostics of wire ropes, particularly compacted steel ropes using a passive method, which the measuring head consists of two head halves which are connected one to each other by means of articulated joint, **characterized in that** it includes a fixedly connected measuring sensors (8) of the system for adjustment position of measuring sensors (8), defined in any one of claims 1-7.
